(19) Europäisches Patentamt
European Patent Office
Office européen des brevets

(11) Numéro de publication : 0 435 751 A1

(12) **DEMANDE DE BREVET EUROPEEN**

(21) Numéro de dépôt : **90403697.7**

(22) Date de dépôt : **20.12.90**

(51) Int. Cl.[5] : **C08G 77/06**, G03F 7/075, G02B 1/10, G02B 6/00

(30) Priorité : **28.12.89 FR 8917315**

(43) Date de publication de la demande : **03.07.91 Bulletin 91/27**

(84) Etats contractants désignés : **DE GB**

(71) Demandeur : **THOMSON-CSF**
**51, Esplanade du Général de Gaulle**
**F-92800 Puteaux (FR)**

(72) Inventeur : **Lagarde, Marc**
**THOMSON-CSF, SCPI, Cédex 67**
**F-92045 Paris la Défense (FR)**
Inventeur : **Broussoux, Dominique**
**THOMSON-CSF, SCPI, Cédex 67**
**F-92045 Paris la Défense (FR)**
Inventeur : **Dubois, Jean-Claude**
**THOMSON-CSF, SCPI, Cédex 67**
**F-92045 Paris la Défense (FR)**

(74) Mandataire : **Guérin, Michel et al**
**THOMSON-CSF SCPI**
**F-92045 PARIS LA DEFENSE CEDEX 67 (FR)**

(54) **Procédé de synthèse de polysilsesquioxanes et applications des produits obtenus.**

(57) L'invention concerne un procédé de synthèse de polysilsesquioxane, comprenant une première étape d'hydrolyse en présence d'éther du trichlorosilane de formule générale $RSiCl_3$ où R représente un radical organique, notamment un alkyle, un aryle, un vinyle ou un allyle, le procédé comprenant en outre les étapes suivantes :

- 2ème étape : dissolution du produit solide obtenu à l'issue de la première étape dans un solvant cétonique anhydre et ajout d'une base, la réaction s'effectuant à chaud, un produit solide étant obtenu après évaporation et séchage.
- 3ème étape : dissolution du produit solide obtenu à l'issue de la deuxième étape dans une cétone anhydre, ajout d'un terminateur de chaîne, la réaction s'effectuant à chaud et la solution obtenue étant filtrée, évaporée et séchée pour donner le polysilsesquioxane désiré,

et la deuxième étape est répétée plusieurs fois.

EP 0 435 751 A1

FIG_1

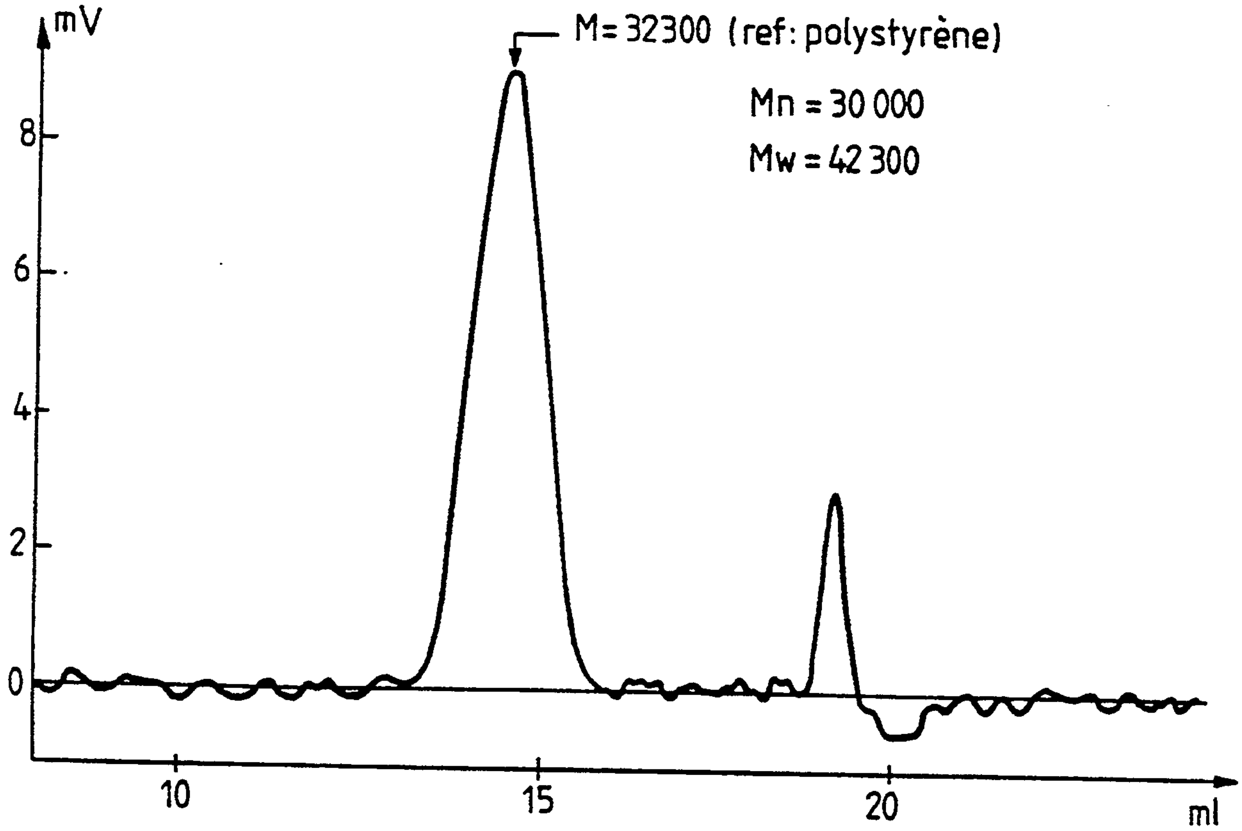

# PROCEDE DE SYNTHESE DE POLYSILSESQUIOXANES ET APPLICATIONS DES PRODUITS OBTENUS

La présente invention concerne une nouvelle voie de synthèse chimique de polysilsesquioxanes, donnant des composés de haute masse moléculaire et de polydispersité réduite et dont la stabilité dans le temps est accrue. Ces améliorations permettent d'utiliser les performances des polysilsesquioxanes dans des applications en microélectronique, pour en faire une résine négative de très haute sensibilité et de bon contraste pour insolation par électrons ou rayons X, ou plus généralement pour une utilisation en optique intégrée.

L'utilisation de polymères silicés en micro-électronique s'est développée ces dernières années car de tels matériaux, plus particulièrement les polysiloxanes, sont filmogènes et leurs utilisations sont multiples en microélectronique.

Les premiers modes de synthèse de polysilsesquioxanes s'inspirent du procédé décrit par G. H. WAGNER et al. dans Ind. and Eng. Chem., vol. 45, n° 2 (1953), pages 367-374. Selon ce procédé, on hydrolyse le composé $RSiCl_3$ (R peut être un radical alkyl, par exemple $CH_3$ ou $C_2H_5$, ou un radical aryle par exemple $C_6H_5$, ou des radicaux allyliques, le plus intéressant du point de vue des applications étant le radical vinyle $CH_2 = CH$). Cette hydrolyse se fait dans un éther à basse température (de 0 à 5°C) avec un grand excès d'eau. Ensuite la phase organique est lavée abondamment et on la traite pour éliminer les résidus d'acide chlorhydrique tout en favorisant l'oligomérisation du produit. La phase éthérée est ensuite séchée et on recueille un oligomère huileux de faible masse.

Une amélioration sensible de ce procédé a été décrit dans FR 2 144 024 qui enseigne que, par optimisation d'une quantité d'ammoniaque ajoutée, on peut réaliser une condensation des produits d'hydrolyse et obtenir un polymère de masse environ 1300 comportant environ 2 % de groupes OH résiduels. Cependant, il existe un inconvénient à ce procédé qui est la polydispersité trop importante et une masse relativement faible ainsi qu'un vieillissement sensible du polymère dû à la présence des groupes OH.

D'autres demandes de brevets ont été déposées pour essayer d'apporter des améliorations aux procédés mentionnés plus haut.

JP 62. 283 128 décrit la synthèse du polyallylsilsesquioxane (dans ce cas R est le groupe $CH_2CH=CH_2$) terminé par des radicaux hydroxyles. Cependant, la présence de ces radicaux hydroxyles rend le composé obtenu peu stable en température.

EP 255 303 décrit un procédé de synthèse du copolymère $(CH_2=CHCH_2SiO_{3/2})_m — (ClCH_2SiO_{3/2})_n$ où m varie entre 0 et 100 et m + n = 100. Les auteurs utilisent le procédé Wagner cité plus haut mais complété par un retraitement ultérieur du produit obtenu. Il s'agit d'une seconde polymérisation effectuée dans un solvant cétonique en présence d'une base. Ce procédé est connu pour augmenter effectivement les masses des polysiloxanes mais ne suffit pas à abaisser la polydispersité au dessous de 1, 5.

Du fait de leur faible masse moléculaire, de leur polydispersité élevée et de groupements terminaux non stabilisés, les matériaux obtenus par ces divers procédés ont des performances limitées en microlithographie électronique ou X.

L'invention consiste à remédier à ces inconvénients. Elle permet d'obtenir des composés dont la masse moléculaire est augmentée (ce qui accroît la sensibilité aux rayonnements et le caractère filmogène) et dont la polydispersité est réduite (ce qui accroît la sélectivité lors de la révélation, donc la résolution). L'invention permet aussi d'obtenir des produits particulièrement stables dans le temps et insensibles aux réactions parasites. Le procédé selon l'invention comprend trois étapes : la première étape correspondant au procédé Wagner, la deuxième étape faisant intervenir un solvant cétonique extrêmement anhydre et la troisième étape utilisant une cétone qui est aussi extrêmement anhydre et un terminateur de chaîne.

L'invention a donc pour objet un procédé de synthèse de polysilsesquioxane, comprenant une première étape d'hydrolyse en présence d'éther, du trichlorosilane de formule générale $RSiCl_3$ où R représente un radical organique, notamment un alkyle, un aryle, un vinyle ou un allyle, ce procédé comprenant en outre les étapes suivantes :

- 2ème étape : dissolution du produit solide obtenu à l'issue de la première étape dans un solvant cétonique anhydre et ajout d'une base, la réaction s'effectuant à chaud, un produit solide étant obtenu après évaporation et séchage,
- 3ème étape : dissolution du produit solide obtenu à l'issue de la deuxième étape dans une cétone anhydre, ajout d'un terminateur de chaîne, la réaction s'effectuant à chaud et la solution obtenue étant filtrée,

évaporée et séchée pour donner le polysilsesquioxane désiré,
caractérisé en ce que la deuxième étape est répétée plusieurs fois.

l'invention sera mieux comprise et d'autres avantages apparaîtront à la lecture de la description qui va suivre, donnée à titre non limitatif, et grâce aux dessins annexés parmi lesquels :

- la figure 1 représente un enregistrement de chromatographie par perméation de gel,
- les figures 2 et 3 représentent des diagrammes de sensibilité du composé obtenu par le procédé de l'invention.

Selon l'invention, on procède donc en trois étapes. Le procédé général de synthèse est le suivant dans le cas du polyvinylsilsesquioxane.

Au cours de la première étape, on verse un mélange d'éther et de vinyltrichlorosilane (50/50 en volume) dans un mélange de glace et d'éther. Après quelques minutes d'hydrolyse on ajoute de l'éther et on agite vigoureusement. On laisse décanter puis on recueille la phase organique qui est lavée, séchée puis évaporée. On peut ajouter un peu d'ammoniaque dans une eau de lavage pour éliminer l'acide chlorhydrique dissout et oligomériser le produit.

Il s'effectue la réaction suivante :

$$CH_2 = CHSiCl_3 + 3H_2O \rightarrow CH_2 = CHSi\,(OH)_3$$

qui donne à son tour des oligomères de structure cyclique et de masse comprise entre 100 et 1500.

Au cours de la deuxième étape, le solide recueilli précédemment est dissous dans un solvant cétonique extrêmement anhydre (c'est-à-dire à teneur en eau contrôlée pratiquement entre 10 et 1000 ppm), et on laisse réagir au moins dix heures à haute température en présence d'une base. Après évaporation et séchage poussés on recommence cette étape plusieurs fois successivement, selon la masse souhaitée. En effet, c'est le temps de réaction dans le solvant extrêmement anhydre qui va déterminer le degré de polymérisation. Les oligomères donnent un composé $HO(CH_2 = CHSiO_{3/2})_n$— OH avec n > 380.

Si la deuxième étape est répétée une fois, le degré n de polymérisation devient supérieur à 500. Si elle est répétée plusieurs fois, il augmente encore.

Un élément critique est le contrôle de la teneur en eau du solvant

Au cours de la troisième étape, le solide obtenu à l'issue de la seconde étape est dissous dans une cétone extrêmement anhydre (c'est-à-dire à teneur en eau contrôlée pratiquement entre 10 et 1000 ppm) et on ajoute une base en quantité légèrement inférieure ainsi qu'un terminateur de chaîne (groupe chimiquement inerte) en large excès. Après quelques heures de réaction à haute température la solution est filtrée pour éliminer le sel puis évaporée et séchée.

Il se passe la réaction suivante lorsque le terminateur de chaîne est $(CH_3)_3SiCl$ :

$$HO\text{-}(CH_2 = CHSiO_{3/2})_n\text{-}OH + (CH_3)_3SiCl \rightarrow$$
$$(CH_3)_3Si\text{-}(CH_2 = CHSiO_{3/2})_n\text{-}Si(CH_3)_3.$$

Une purification ultime du polymère est obtenue par une reprécipitation classique dans un mélange solvant/non solvant.

Ce procédé peut être appliqué à la synthèse d'autres polysilsesquioxanes, c'est-à-dire de polymères de formule $(RSiO_{3/2})_n$ où R est un radical de nature quelconque (par exemple un alkyle tel le méthyle ou un aryle, en particulier le phényle).

On peut également utiliser comme terminateur de chaîne un composé du type $Z_3SiCl$, Z étant un groupement alkyle ou alkoxy.

EXEMPLE DE SYNTHESE

Dans un mélange de 500 g de glace pilée et 80 $cm^3$ d'éther éthylique on verse au goutte-à-goutte un mélange de 60 $cm^3$ d'éther et 60 $cm^3$ de vinyltrichlorosilane. Après quelques minutes on rajoute 200 $cm^3$ d'éther. L'extrait éthéré est lavé, agité avec 2 $cm^3$ d'ammoniaque puis relavé jusqu'à neutralité, évaporé et séché. On recueille de l'ordre de 30 g de produit. Ce produit est dissous dans 240 $cm^3$ de méthyléthylcétone fraîchement distillée. On ajoute 15 $cm^3$ de triéthylamine distillée et on laisse à reflux pendant 15 heures. Après évaporation, séchage sous vide poussé on redissout le polymère dans 240 $cm^3$ de méthyléthylcétone fraîchement distillée en présence de 7 $cm^3$ de triéthylamine et 6 $cm^3$ de $(CH_3)_3$ SiCl comme terminateur.

Le produit est ensuite refroidi pour favoriser le filtrage du chlorhydrate de triéthylamine, évaporé et séché.

Le polymère obtenu (25 à 28 g) est pulvérulent et blanc. On le purifie par reprécipitation dans un mélange méthanol/méthyléthylcétone.

Avec ce produit, on obtient typiquement une masse moléculaire égale à 40 000 et une dispersité de 1,4.

La figure 1 représente un enregistrement GPC (chromatographie par perméation de gel) représentatif du produit obtenu.

Les conditions correspondant à la première étape ne sont pas critiques, et peuvent donc être modifiées

légèrement, comme cela est généralement le cas dans la littérature.

Pour la deuxième étape on pourra opérer avec une quantité de solvant réduite, de 50 à 250 $cm^3$, et on pourra utiliser d'autres cétones (méthylisobutylcétone par exemple) ou même l'acétate d'éthyle, le toluène, le benzène ou des éthers à température d'ébullition suffisamment élevée. La base utilisée peut être une autre amine (tributylamine par exemple) ou la pyridine.

Ces remarques s'appliquent aussi à la troisième étape ; en outre le terminateur pourra être un autre composé de la famille $Z_3SiCl$.

Une répétition de la deuxième étape, avant de passer à la troisième étape, est particulièrement avantageuse. Ainsi pour l'exemple de synthèse ci-dessus, en pratiquant deux fois la deuxième étape, on obtient une masse moléculaire de 50 000 au lieu de 40 000, la valeur de la dispersité ne changeant pas. La troisième peut également être renouvelée deux ou plusieurs fois.

Le polysilsesquioxane est un matériau sensible aux électrons, aux rayons X ainsi qu'aux UV lointoins, du fait de la présence des groupes vinyliques qui réticulent comme le montrent les courbes de sensibilité du matériau en fonction des rayons X (figure 2) et en fonction des électrons (figure 3). Cette résine peut donc être imagée en microlithographie selon les procédés classiques et plus particulièrement dans les processus bicouches.

Le tableau 1, placé en fin de description, présente les valeurs relevées concernant les paramètres sensibilité et contraste pour du polysilsesquioxane (PVS) synthétisé selon le procédé de l'invention et pour la résine commerciale de nature voisine : la SNR (de la Société Japan Synthetic Rubber) qui est une résine contenant du silicium. On constate, d'après ce tableau, que le composé selon l'invention présente une sensibilité nettement accrue, avec un contraste un peu réduit, mais cependant suffisant car ces résines sont destinées à être utilisées dans des processus bicouches, donc en couche très mince. En outre le PVS se transforme très rapidement en silice sous plasma oxygène et n'évolue plus ensuite : sa vitesse d'érosion sous plasma oxygène est évaluée à 50 angströms/minute, soit nettement inférieure à celle de la SNR.

Le tableau 2, placé en fin de description, présente les caractéristiques de quelques résines commerciales non siliciées comparées au PVS synthétisé par le procédé selon l'invention. Ces résines non siliciées sont utilisables uniquement en processus tricouche. Le tableau 2 regroupe les résines KPR et KTFR commercialisées par la Société KODAK et les résines CBR M901, CIR 701 et CIR 70E commercialisées par la Société Japan Synthetic Rubber.

On constate que les performances du PVS sont très satisfaisantes, même sans tenir compte de la simplification du processus de lithographie qu'il apporte. En conséquence, le PVS peut être utilisé comme couche imageable en microlithographie X ou électronique pour la fabrication de structures submicroniques. En outre le PVS peut être utilisé pour la fabrication de masques de silice selon l'enseignement de FR 2 144 024. Du fait de sa faible absorption du proche ultraviolet au proche infrarouge, le PVS peut être utilisé comme couche anti-reflets selon l'enseignement de K.L. MARSHALL et al., Journal of Applied Physics Vol. 64 (5), Sept. 1988, pages 2279-2285. Son indice de 1,44 permet de l'utiliser dans la réalisation de microguides de lumière, et plus généralement dans tout dispositif d'interconnexion optique. Le PVS peut être rendu photosensible, moyennant l'adjonction d'un photosensibilisateur, selon le procédé bien connu de l'homme de l'art. Sa haute résolution lui permet d'être utilisé comme support d'enregistrement optique, et en particulier comme mémoire pour enregistrement optique type WORM (Write Once Read Many). Le PVS peut encore être utilisé pour réaliser des couches tampons dans les systèmes multicouches de polymères.

| Produit | Paramètre | Rayons X | Electrons |
|---|---|---|---|
| SNR | Sensibilité | 65 mJ/cm² | 13 µC/cm² |
| | Contraste | 1,6 | 1,7 |
| PVS | Sensibilité | 2,1 mJ/cm² | 2,9 µC/cm² |
| | Contraste | 1,4 | 1,4 |

TABLEAU I

| Produit | Sensibilité | Contraste |
|---|---|---|
| KPR | 10 mJ/cm² | 1,5 |
| KTFR | 25 mJ/cm² | 0,9 |
| CBR M901 | 0,8 mJ/cm² | 0,9 |
| CIR 701 | 6 mJ/cm² | 1,1 |
| CIR 70E | 3,4 mJ/cm² | 0,9 |
| PVS | 2,1 mJ/cm² | 0,4 |

TABLEAU 2

**Revendications**

**1.** - Procédé de synthèse de polysilsesquioxane, comprenant une première étape d'hydrolyse en présence

d'éther du trichlorosilane de formule générale $RSiCl_3$ où R représente un radical organique, notamment un alkyle, un aryle, un vinyle ou un allyle, ce procédé comprenant en outre les étapes suivantes :

- 2ème étape : dissolution du produit solide obtenu à l'issue de la première étape dans un solvant cétonique anhydre et ajout d'une base, la réaction s'effectuant à chaud, un produit solide étant obtenu après évaporation et séchage.
- 3ème étape : dissolution du produit solide obtenu à l'issue de la deuxième étape dans une cétone anhydre, ajout d'un terminateur de chaîne, la réaction s'effectuant à chaud et la solution obtenue étant filtrée, évaporée et séchée pour donner le polysilsesquioxane désiré,

caractérisé en ce que la deuxième étape est répétée plusieurs fois.

**2.** - Procédé de synthèse selon la revendication 1, caractérisé en ce que le radical R représente un groupement vinyl.

**3.** - Procédé de synthèse selon l'une des revendications 1 ou 2, caractérisé en ce que le terminateur de chaîne est un composé de la famille $Z_3SiCl$ ou Z est un groupement alkyle ou alkoxy.

**4.** - Utilisation de polysilsesquioxane obtenu par le procédé selon l'une quelconque des revendications 1 à 3 comme résine négative.

**5.** - Utilisation de polysilsesquioxane obtenu par le procédé selon l'une quelconque des revendications 1 à 3 comme couche anti-reflets.

**6.** - Utilisation de polysilsesquioxane obtenu par le procédé selon l'une quelconque des revendications 1 à 3 pour réaliser des guides d'onde.

**7.** - Utilisation de polysilsesquioxane obtenu par le procédé selon l'une quelconque des revendications 1 à 3 comme couche tampon dans les systèmes multicouches de polymères.

FIG_1

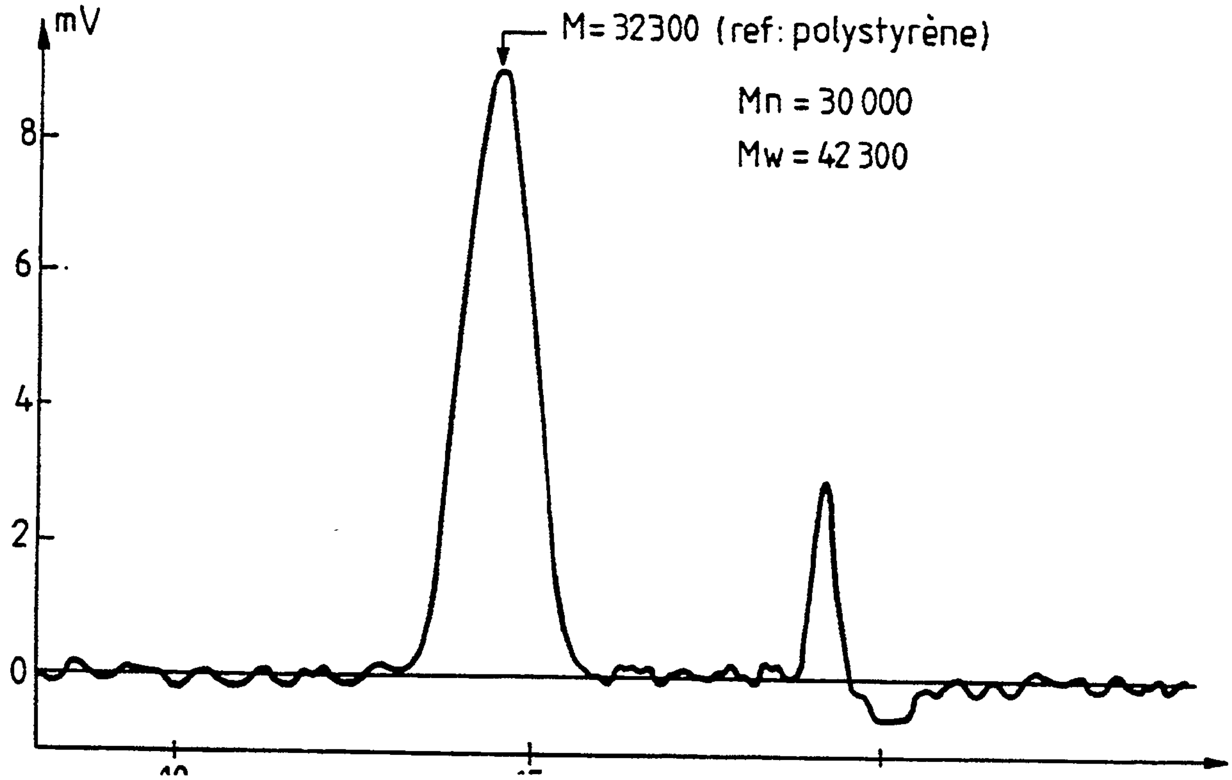

FIG_2

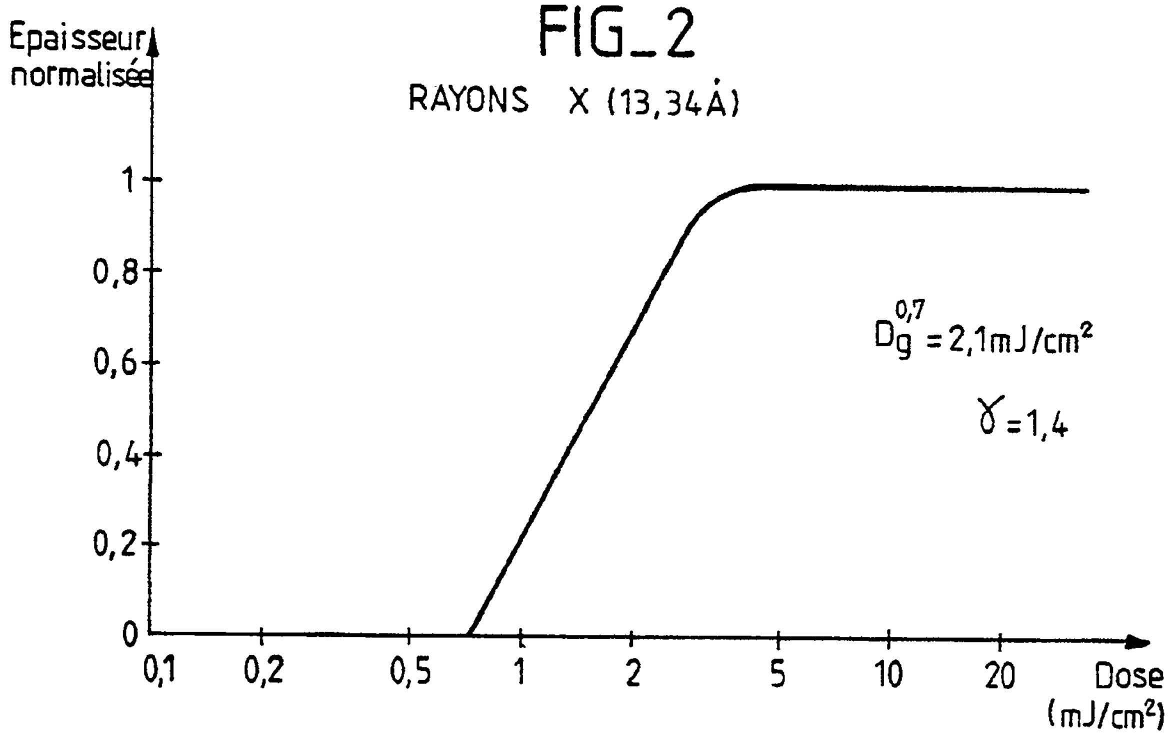
Epaisseur normalisée
RAYONS X (13,34Å)
1
0,8
0,6
0,4
0,2
0
0,1
0,2
0,5
1
2
5
10
20
Dose (mJ/cm²)
Dg 0,7 = 2,1mJ/cm²
γ=1,4

FIG_3

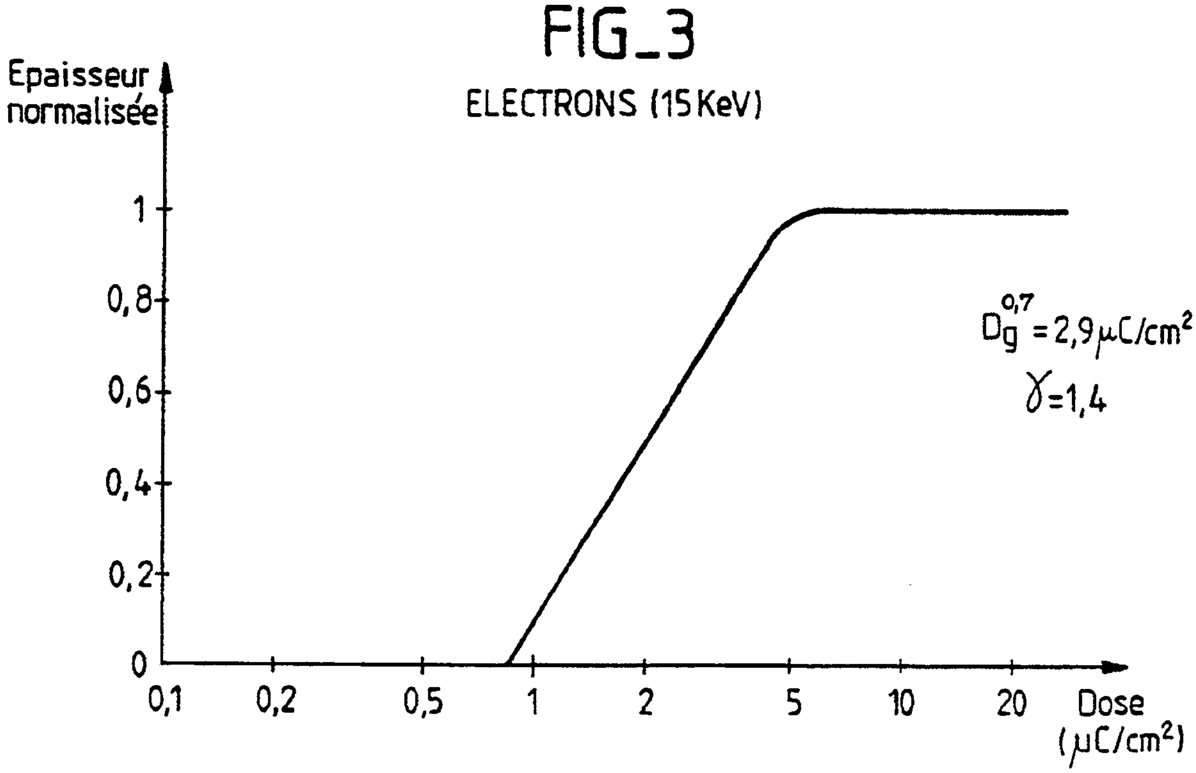
Epaisseur normalisée
ELECTRONS (15 KeV)
1
0,8
0,6
0,4
0,2
0
0,1
0,2
0,5
1
2
5
10
20
Dose (μC/cm²)
Dg 0,7 = 2,9μC/cm²
γ=1,4

Office européen des brevets

# RAPPORT DE RECHERCHE EUROPEENNE

Numero de la demande

EP 90 40 3697

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | WO-A-8605284 (HUGHES AIRCRAFT COMPANY)<br>* revendications 2-8, 12-18 *<br>* page 5, lignes 1 - 9 *<br>* page 6, ligne 15 - page 8, ligne 15 *<br>--- | 1-4 | C08G77/06<br>G03F7/075<br>G02B1/10<br>G02B6/00 |
| A | EP-A-163538 (FUJITSU LIMITED)<br>* revendications *<br>* page 7, ligne 17 - page 9, ligne 26 *<br>* exemple 2 *<br>--- | 1-4 | |
| A | FR-A-2303819 (THOMSON-CSF)<br>* revendications *<br>* page 1, lignes 1 - 3 *<br>--- | 1, 4, 6 | |
| A | EP-A-198976 (FUJITSU LIMITED)<br>* revendications 5-8 *<br>* page 12, lignes 1 - 27 *<br>--- | 1, 3 | |
| A,D | EP-A-255303 (OKI ELECTRIC ELECTRIC INDUSTRY COMPANY, LIMITED)<br>* revendications 1, 7-10 *<br>* page 3, lignes 15 - 42 *<br>----- | 1, 4 | |

| DOMAINES TECHNIQUES RECHERCHES (Int. Cl.5 ) |
|---|
| C08G<br>G03F<br>H01L<br>G03G<br>B32B<br>G02B |

Le présent rapport a été établi pour toutes les revendications

| Lieu de la recherche | Date d'achèvement de la recherche | Examinateur |
|---|---|---|
| LA HAYE | 09 AVRIL 1991 | HOLLENDER C.J.F |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)